# EUROPÄISCHE PATENTSCHRIFT

(11) **EP 3 921 607 B1**
(45) Veröffentlichungstag und Bekanntmachung des Hinweises auf die Patenterteilung: **14.12.2022**
(21) Anmeldenummer: 20704453.8
(22) Anmeldetag: 04.02.2020
(51) Int. Cl.: G01G 21/28, G01G 23/48

(54) **GRAVIMETRISCHES MESSSYSTEM**
GRAVIMETRIC MEASURING SYSTEM
SYSTÈME DE MESURE GRAVIMÉTRIQUE

(30) Priorität: 05.02.2019 DE 102019102801
(43) Veröffentlichungstag der Anmeldung: 15.12.2021
(73) Patentinhaber: Sartorius Lab Instruments GmbH & Co. KG, 37079 Göttingen (DE)
(72) Erfinder: STÄNDER, Malte, 37308 Heiligenstadt (DE); VON STEUBEN, Jan, 37075 Göttingen (DE); LAUBSTEIN, Michael, 37077 Göttingen (DE); HOLST, Heyko, 370585 Göttingen (DE)
(74) Vertreter: Novagraaf International SA
(86) Internationale Anmeldenummer: PCT/EP2020/052676
(87) Internationale Veröffentlichungsnummer: WO 2020/161101

(56) Entgegenhaltungen:
- EP-A1- 1 312 902
- EP-A1- 1 367 372
- DE-A1-102014 101 558

## Beschreibung

### Gebiet der Erfindung

Die Erfindung bezieht sich auf ein gravimetrisches Messsystem, umfassend
- eine Waage mit einem von einer Wägeraumwandung umgebenen Wägeraum, einem elektromechanischen Wägesystem und einer elektronischen Steuereinrichtung zur Steuerung des Systembetriebs gemäß in ihrem Speicher hinterlegten Regeln sowie
- eine Mehrzahl von Funktionsmodulen, die bedarfsweise in an der Wägeraumwandung angeordnete Modulaufnahmen einsetzbar sind.

### Stand der Technik

Derartige gravimetrische Messsysteme sind bekannt aus der EP 1 195 584 A1.

Analyse- und Laborwaagen, insbesondere solche, die auf dem Prinzip der elektromagnetischen Kompensation arbeiten, sind allgemein bekannt. Ein elektromechanisches Wägesystem, d. h. ein typischerweise komplexes Hebelwerk mit einer eingangsseitigen Lastaufnahme und einer ausgangsseitigen Tauchspulenanordnung, ist dabei in einem Wägesystemraum angeordnet, der eine möglichst gute Abschirmung gegenüber Umgebungseinflüssen gewähren soll. Ein mit der Lastaufnahme verbundener Träger ragt in einen üblicherweise benachbarten Wägeraum hinein, der ebenfalls, nämlich durch seine Wägeraumwandung, weitgehend von der Umgebung abgeschirmt ist. Die Wägeraumwandung setzt sich üblicherweise aus dem Wägeraumboden, den Wägeraumdeckel, Wägeraumseitenwänden sowie eine Vorder- und Rückwand zusammen. Die Rückwand kann häufig mit einer Wand des Wägesystemraums zusammenfallen. Eine oder beide Seitenwände des Wägeraums sind häufig als bewegbare Windschutz-Elemente ausgebildet. Auch der Deckel und/oder die Vorderseite können, in der Regel verschließbare, Zugangsöffnungen enthalten. Die Kopplung des Trägers zur Lastaufnahme des Wägesystems durchsetzt üblicherweise die Rückwand oder den Boden des Wägeraums.

Weiter enthalten derartige Waagen stets eine Steuereinrichtung, die insbesondere die Wägesensorik ansteuert und dabei speziell die Tauchspulenanordnung des Wägesystems regelt. Allerdings können die Steuereinrichtungen moderner Waagen deutlich komplexer ausgestaltet sein und insbesondere verschiedene Betriebsvarianten des Systembetriebs zur Verfügung stellen. Solche Betriebsvarianten können die Steuerung der Sensorik oder einer Kühlvorrichtung betreffen, sie können sich jedoch alternativ oder zusätzlich auf die Ansteuerung bestimmter Hilfseinrichtungen im oder am Wägeraum beziehen. Rein beispielhaft seien eine Kühlvorrichtung, eine Windschutzsteuerung, Hebevorrichtungen innerhalb des Wägeraums, Beleuchtungseinrichtungen und ähnliches genannt.

Aus der eingangs genannten, gattungsbildenden Druckschrift ist es bekannt, solche Hilfseinrichtungen mit Wägefunktionsbezug in Form von Modulen, d. h. als wägefunktionsbezogene Module, kurz Funktionsmodule, vorzuhalten und im Wägeraum, insbesondere an dessen Rückwand, eine schienenartige Haltevorrichtung vorzusehen, welche unterschiedliche mechanische Schnittstellen aufweist, an welchen im konkreten Einzelfall benötigte Funktionsmodule in der jeweils benötigten Position festgelegt werden können. Mit anderen Worten sind besagte Funktionsmodule bedarfsweise in entsprechende Modulaufnahmen an der Wägeraumwandung einsetzbar. Ein solch modulares System ist insbesondere in Laborumgebungen vorteilhaft, in denen mit ein und derselben Waage unterschiedliche Wägeaufgaben durchgeführt werden müssen. Die Waage kann dann vom Benutzer selbst entsprechend seinem konkreten Bedarf im Einzelfall konfektioniert werden. Selbst in Fällen, in denen die mechanischen Schnittstellen so gestaltet sind, dass ein Modulaustausch durch den Benutzer unmöglich ist, sind solch modulare Systeme auch herstellerseitig vorteilhaft. Aufbauend auf demselben Waagengrundkörper können durch Wahl der in die Modulaufnahmen eingesetzten Funktionsmodule Waagen für unterschiedliche Wägeaufgaben vorkonfektioniert werden. Die Anzahl herzustellender Spezialteile verringert sich drastisch, was zu einer deutlichen Kosteneinsparung führt.

Weitgehend unproblematisch ist dieses Konzept, wenn ausschließlich passive Funktionsmodule Einsatz finden. Als passive Funktionselemente seien hier solche bezeichnet, die lediglich eine mechanische Ankopplung zu ihrer Fixierung benötigen. Rein beispielhaft seien hier Träger, Halter, Abschirmungen etc. angegeben. Aktive Funktionsmodule hingegen, die eigene elektrische oder elektronische Komponenten enthalten, können bei dem bekannten gravimetrischen Messsystem zwar auch mittels der angebotenen, mechanischen Schnittstelle im Wägeraum fixiert werden; sie bedürfen jedoch zusätzlicher Anschlüsse, die individuell gestaltet werden müssen. Dies ist im Hinblick auf die oben erläuterte Flexibilisierung bei der Konfektionierung von gravimetrischen Messsystemen nachteilig.

Die nachveröffentlichte EP 3 557 199 A1 offenbart eine Waage mit einer aus mehreren Wandelementen zusammensetzbaren Wägeraum-Rückwand, deren Höhe auf diese Weise an unterschiedliche Windschutz-Höhen anpassbar ist, mithin Wägeräume unterschiedlicher Höhen aufbaubar sind.

Die EP 1 312 902 A1 offenbart eine Waage, an deren Wägeraum-Rückwand eine elektronische Zusatzeinheit, in welcher Versorgungseinheiten, bspw. eine Batterie, oder auch eine Steuerungselektronik angeordnet sein können, mithin ein Funktionsmodul im hiesigen Sinne, anbringbar ist.

Auch die US 2010/0276213 A1 offenbart eine Waage, an deren Wägeraum-Rückwand eine Steuerungselektronik angeordnet ist. Diese ist mechanisch und elektronisch mit einer über dem Lastaufnehmer angeordneten Dosierdüse verbunden, sodass die Waage insgesamt als Dosiervorrichtung nutzbar ist.

Die EP 1 396 711 B1 offenbart eine Waage mit einem ohne jegliche Funktionsmodule ausgestatteten Wägeraum, die eine über ein thermoelektrisches Element vermittelte Wärmeabfuhr der Wägeelektronik und aus dem Wägeraum aufweist, wobei die spezielle thermische Ankopplung an die Wägeraum-Rückwand für die Ausbildung eines Temperaturgradienten innerhalb des Wägeraums sorgt.

Die DE 10 2014 101 561 A1 offenbart eine gravimetrische Dosiervorrichtung mit einem im Wägeraum angeordneten Klimamessmodul. Auf Basis der damit ermittelten Klimadaten können im Rahmen des Dosiervorgangs zu mischende Komponenten außerhalb der Vorrichtung vortemperiert werden.

Weiterer Stand der Technik ist durch die Schriften EP 1 367 372 A1, EP 1 312 902 und DE 10 2014 101 558 A1 gegeben.

### Aufgabenstellung

Es ist die Aufgabe der vorliegenden Erfindung, ein gattungsgemäßes gravimetrisches Messsystem derart weiterzubilden, dass eine bedarfsgerecht individualisierte Konfektionierung erleichtert wird.

### Darlegung der Erfindung

Diese Aufgabe wird in Verbindung mit den Merkmalen des Oberbegriffs von Anspruch 1 dadurch gelöst, dass weiter wägefunktionslose Blenden umfasst sind und die wenigstens eine Wägeraumwand als eine z.B. aus Pfosten und Streben aufgebaute Trägerstruktur ausgebildet ist, welche den überwiegenden Teil der Wandfläche einnehmende Freilassungen darstellende, besagte Modulaufnahmen bildende Ausnehmungen aufweist, wobei die Ausnehmungen wahlweise durch besagte, räumlich an sie angepasste wägefunktionslose Blenden oder besagte Funktionsmodule verschließbar sind. Bevorzugte Ausführungsformen sind Gegenstand der abhängigen Ansprüche.

Die Erfindung sieht vor, wenigstens eine Wägeraumwand, bevorzugt mehrere Wägeraumwände, als Gerippe- oder Gitterstruktur aufzubauen, welche mehrere, gleich gestaltete Ausnehmungen zum Einsetzen unterschiedlicher Funktionsmodule bietet. Aufgrund der gleichen Gestaltung der Modulaufnahmen können entsprechend gleich gestaltete, jedoch unterschiedlich wirksame Funktionsmodule an quasi beliebiger Stelle der Wägeraumwandung, insbesondere dort, wo sie gemäß aktuellem Bedarf benötigt werden, installiert werden. Die Gestaltung der Modulaufnahmen als Ausnehmungen erlaubt es zudem, zusätzliche Anschlüsse, auf die weiter unten noch eingegangen werden soll, außerhalb des Wägeraums zu positionieren, sodass sich im Wägeraum selbst nur die dort zwingend erforderlichen Komponenten befinden. Dies ist im Hinblick auf Sicherheit, Sauberkeit, Temperaturmanagement etc. von großer Bedeutung.

Da es Ziel der Erfindung ist, eine besondere Flexibilität bei der Konfektionierung einer Waage zu bieten, sind bevorzugt mehr Modulaufnahmen vorgesehen, als bei typischen Anwendungsfällen Funktionsmodule installiert werden müssen. Um gleichwohl die angestrebte "Aufgeräumtheit" des Wägeraums zu gewährleisten, sieht die Erfindung vor, dass das gravimetrische Messsystem außer der Waage und den Funktionsmodulen auch wägefunktionslose Blenden aufweist, mit denen diejenigen Modulaufnahmen verschlossen werden können, in denen gerade kein Funktionsmodul installiert ist. Auf diese Weise lassen sich für unterschiedliche Anwendungen unterschiedliche Waagen konfektionieren, die jedoch sämtlich einen Wägeraum mit auf das für die angestrebte Funktion erforderliche Minimum reduzierter Ausstattung aufweisen.

Wie oben bereits angedeutet, gewähren die erfindungsgemäßen Modulaufnahmen bevorzugt nicht nur eine rein mechanische Fixierungsschnittstelle. Vielmehr werden insbesondere im Hinblick auf aktive Funktionsmodule weitere Schnittstellen zur Verfügung gestellt. So ist bei der Erfindung vorgesehen, dass die Trägerstruktur im Bereich wenigstens einer ihrer Ausnehmungen eine geräteseitige Identifikations-Schnittstellenkomponente aufweist, die beim Einsetzen eines Funktionsmoduls von einer korrespondierenden, modulseitigen Identifikations-Schnittstellenkomponente identifikationsdatenübertragend kontaktiert wird. Dabei können die geräteseitigen Identifikations-Schnittstellenkomponenten als optische, magnetische, taktile, funktechnische oder elektronische Empfangseinheiten und die modulseitigen Identifikations-Schnittstellenkomponenten als korrespondierende optische, magnetische, taktile, funktechnische oder elektronische Sendeeinheiten ausgebildet sein. Hintergrund dieser Maßnahmen ist die Schaffung einer Möglichkeit der automatischen Erkennung und Identifizierung der jeweils installierten Funktionsmodule. Insbesondere kann eine automatische Erkennung der Modulkonstellation durch die Steuereinheit der Waage vorgesehen sein. Diese Information kann dann zur Anpassung der Funktionssteuerung der Waage verwendet werden.

Insbesondere können, je nach erkannter Modulkonstellation, unterschiedliche Varianten des Waagenbetriebssystems aktiviert werden. Solche Varianten können die Ansteuerung der Funktionsmodule selbst betreffen. Andererseits können auch Aspekte betroffen sein, die sich auf die Gesamtvorrichtung beziehen. So ist bei einer alternativ oder zusätzlich realisierbaren Ausführungsform der Erfindung vorgesehen, dass die Trägerstruktur im Bereich wenigstens einer ihrer Ausnehmungen eine mit einer zentralen Kühlvorrichtung thermisch verbundene, geräteseitige Thermo-Schnittstellenkomponente aufweist, die beim Einsetzen eines (insbesondere aktiven) Funktionsmoduls von einer korrespondierenden, modulseitigen Thermo-Schnittstellenkomponente, thermisch kontaktiert wird. Derartige Thermo-Schnittstellen erlauben die gezielte Abführung von Wärme, die in aktiven Funktionsmodulen von deren elektrischen und elektronischen Komponenten erzeugt wird. Rein beispielhaft seien hier motorische Einheiten, Beleuchtungseinheiten, Ionisatoren etc. angegeben. Insbesondere in Kombination mit den zuvor genannten identifikations-Schnittstellen kann die Steuereinrichtung in Abhängigkeit von der erkannten Modulkonstellation spezielle Betriebsvarianten der Kühlvorrichtung aktivieren, sodass trotz der Unterschiede in Betrag und Verteilung der Wärmeleistung bei unterschiedlichen Modulkonstellationen gleichwohl eine exakte Kühlkompensation realisiert wird. Hierdurch kann eine stets gleiche, optimierte Temperaturverteilung im Wägeraum erzielt werden.

Selbstverständlich sollten die Modulaufnahmen auch zur elektrischen und elektronischen, insbesondere datentechnischen Kontaktierung der aktiven Funktionsmodule entsprechende Schnittstellenkomponenten aufweisen, die dann bei Installation der Funktionsmodule vorzugsweise automatisch von entsprechenden modulseitigen Schnittstellenkomponenten kontaktiert werden.

Üblicherweise ist diejenige Wägeraumwand, an welcher sich der größte Bedarf für die Installation von Funktionsmodulen ergibt, die Trennwand zum Wägesystemraum, d.h. zu demjenigen Raum, in dem sich das mechatronische Wägesystem, z.B. ein DMS-(Dehnmessstreifen) oder EMK- (elektromagnetische Kompensation) System, befindet. Dieser Wägesystemraum muss, damit die entsprechende Waage ggf. den gesetzlichen Eichanforderungen genügt, komplett versiegelt, d.h. für den Waagenbenutzer unzugänglich sein. Das steht in scheinbarem Zielkonflikt mit der oben erläuterten Zugänglichkeit sämtlicher Schnittstellen. Zur Überbrückung dieses Zielkonfliktes sieht eine Weiterbildung der Erfindung daher vor, dass im Fall, dass die als besagte Trägerstruktur ausgebildete Wägeraumwand als ein Trennelement zwischen dem Wägeraum und einem Wägesystemraum, der das mit einem im Wägeraum angeordneten Wägegutträger verbundene Wägesystem umschließt, positioniert ist, wobei die Ausnehmungen der Trägerstruktur wägesystemraumseitig durch eine fest installierte Abschlusswand verschlossen sind. Mit anderen Worten wird die fragliche Wägeraumwand doppelschichtig ausgebildet. Zum Wägeraum hin sind die erfindungsgemäßen Ausnehmungen offen und weisen die vom Wägeraum her zugänglichen, geräteseitigen Schnittstellenkomponenten auf. Wägesystemraumseitig hingegen sind sämtliche Ausnehmungen durch eine nicht lösbare Wandung verschlossen, sodass ein Durchgriff vom Wägeraum zum Wägesystemraum ausgeschlossen ist. Der Wägesystemraum bleibt damit versiegelt, sodass die Eichfähigkeit der Waage nicht beeinträchtigt ist. Gleichzeitig jedoch können die eingangs erläuterten Vorteile der Erfindung im Hinblick auf die Flexibilität bei der Konfektionierung voll genutzt werden.

Weitere Merkmale und Vorteile der Erfindung ergeben sich aus der nachfolgenden speziellen Beschreibung und den Zeichnungen.

### Kurzbeschreibung der Zeichnungen

Es zeigen:
- Figur 1:: eine schematische Darstellung eines erfindungsgemäßen gravimetrischen Messsystems im Montageendzustand mit unvollständig dargestellter Wägeraumwandung,
- Figur 2:: die Wägeraumrückwand der Waage des gravimetrischen Messsystems von Figur 1 in einem Montagezwischenzustand ohne eingesetzte Funktionsmodule oder Blenden,
- Figur 3:: eine unvollständige Schnittdarstellung der Wägeraumrückwand der Waage des gravimetrischen Messsystems von Figur 1 und daran angrenzender Bereiche sowie
- Figur 4:: eine schematische Darstellung einer bevorzugten Kühlungssteuerung der Waage des gravimetrischen Messsystems von Figur 1.

### Beschreibung bevorzugter Ausführungsformen

Gleiche Bezugszeichen in den Figuren deuten auf gleiche oder analoge Elemente hin.

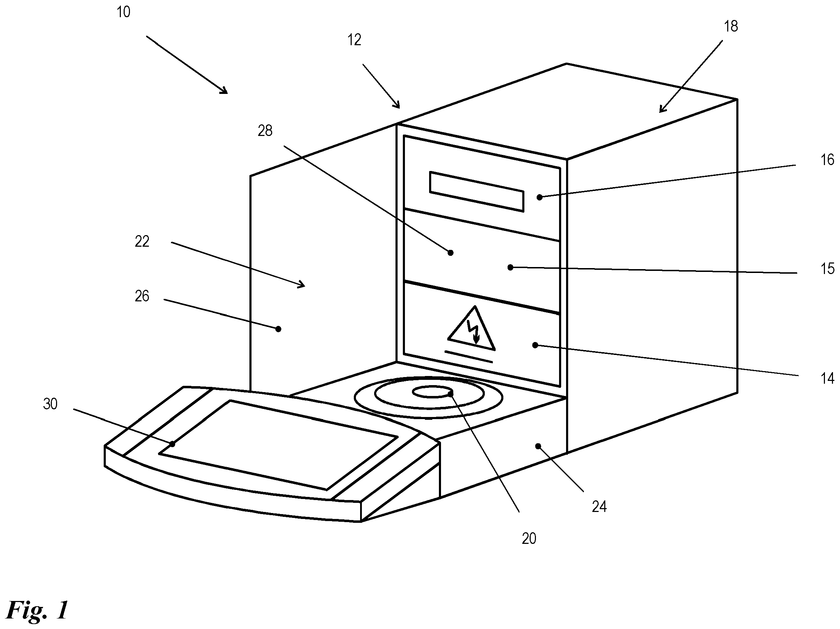

Figur 1 zeigt eine schematische Darstellung eines erfindungsgemäßen gravimetrischen Messsystems 10, welches im Wesentlichen aus einer Waage 12 und zwei darin eingesetzten Funktionsmodulen 14, 16 sowie einer Blende 15 besteht. Bei der gezeigten Ausführungsform ist das mit dem Bezugszeichen 14 versehene Funktionsmodul eine zur Erkennung von Barcodes geeignete Laserscannereinheit und das mit dem Bezugszeichen 16 versehene Funktionsmodul eine Beleuchtungseinheit. Die konkreten Funktionen der Funktionsmodule 14, 16 spielen im Kontext der vorliegenden Erfindung jedoch keine Rolle.

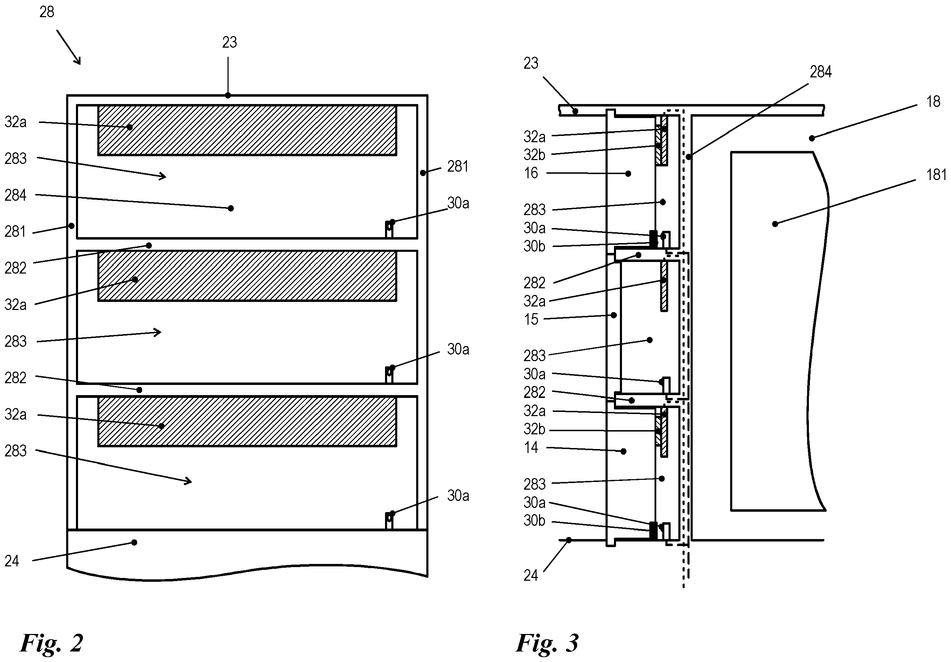

Die Waage 12 umfasst bei der gezeigten Ausführungsform im Wesentlichen drei Bereiche, nämlich einen Wägesystemraum 18, in dem ein in Figur 3 angedeutetes Wägesystem 181 angeordnet ist. Der konkrete Aufbau des Wägesystems 181 spielt im Kontext der vorliegenden Erfindung keine Rolle. Das Wägesystem 181 umfasst in jedem Fall eine nicht gesondert dargestellte Lastaufnahme, die mit einem Wägegutträger 20 verbunden ist, welcher seinerseits in einem bei der dargestellten Ausführungsform an den Wägesystemraum 18 angrenzenden Wägeraum 22 angeordnet ist. Der Wägeraum 22 ist von einer Wägeraumwandung umgeben, die in Figur 1 nur unvollständig dargestellt ist. Insbesondere sind der von dem Wägegutträger 20 durchsetzte Wägeraumboden 24, eine Wägeraumseitenwand 26 sowie eine Wägeraumrückwand 28, auf die weiter unten noch näher einzugehen sein wird, dargestellt. Die Wägeraumrückwand 28 ist bei der Darstellung von Figur 1 im Wesentlichen durch die Frontseiten der Funktionsmodule 14, 16 sowie die zwischen diesen Funktionsmodulen 14, 16 angeordnete Blende 15 verdeckt. Typischerweise umfasst die Wägeraumwandung zusätzlich eine weitere Wägeraumseitenwand, eine Wägeraumvorderwand und einen (nur in den Figuren 2 und 3 angedeuteten) Wägeraumdeckel 23, die aus Gründen der besseren Übersichtlichkeit in Figur 1 jedoch nicht dargestellt sind.

Weiter umfasst die Waage 12 eine Elektronikeinheit 30, die bei der gezeigten Ausführungsform im Wesentlichen eine großformatige Anzeige umfasst. Die Elektronikeinheit 30 kann zusätzlich eine Steuereinrichtung enthalten, auf die weiter unten noch näher einzugehen sein wird. Diese Steuereinrichtung kann jedoch auch an anderer Stelle der Waage 12 angeordnet sein. Als günstig wird angesehen, wenn diese Steuereinheit thermisch isoliert vom Wägesystemraum 18 sowie vom Wägeraum 22 angeordnet ist.

Figur 2 zeigt eine Frontalansicht der Wägeraumrückwand 28, allerdings ohne die eingesetzten Funktionsmodule 14, 16 und ohne die Blende 15. Figur 3 zeigt eine Schnittansicht der Wägeraumrückwand 28 und angrenzender Bereiche der Waage 12, wobei die Darstellung von Figur 3 allerdings auch die eingesetzten Funktionsmodule 14, 16, sowie die eingesetzte Blende 15 zeigt. Trotz dieses Unterschiedes erleichtert eine Zusammenschau der Figuren 2 und 3 das Verständnis der nachfolgenden Beschreibung.

Die Wägeraumrückwand 28 ist aus senkrechten Pfosten 281 und quer dazu angeordneten Streben 282 aufgebaut. Zwischen diesen erstrecken sich Ausnehmungen 283, die hier auch als Modulaufnahmen 283 bezeichnet werden. Wägesystemraumseitig weist die Wägeraumrückwand 28 eine den Wägesystemraum 18 versiegelnde Abschlusswand 284 auf, die einen Durchgriff durch die Modulaufnahmen 283 in den Wägesystemraum 18 verhindert. Bei der dargestellten Ausführungsform ist die Abschlusswand 284 zugleich die Vorderwand des Wägesystemraums 18.

Die Modulaufnahmen 283 dienen der räumlich angepassten Aufnahme der Funktionsmodule 14, 16. In die in den Figuren 2 und 3 mittlere Modulaufnahme 283 ist bei der Ausführungsform der Figuren 1 und 3 kein Funktionsmodul eingesetzt. Diese Ausnehmung 283 zwischen den Pfosten 281 und Streben 282 ist durch die Blende 15 zum Wägeraum hin verschlossen. Die Modulaufnahmen 283 sind hinsichtlich ihrer nachfolgend näher zu beschreibenden Ausstattung identisch ausgebildet, sodass die Funktionsmodule 14, 16 ebenso wie andere, kompatibel ausgebildete Funktionsmodule in jede der Modulaufnahmen 283 einsetzbar sind. Hinsichtlich ihrer Größe sind die Modulaufnahmen 283 bevorzugt identisch, besonders bevorzugt ohne Trennelement ineinander übergehend ausgebildet, sodass Funktionsmodule 14, 16, deren Größe einem ganzzahligen Vielfachen einer Einheitsgröße entspricht, exakt in eine oder in mehrere einander benachbarte Modulaufnahmen 283 passend eingesetzt werden können.

Denkbar ist auch, dass die Größen der Modulaufnahmen 283 selbst unterschiedliche ganzzahlige Vielfache einer Einheitsgröße sind. Gleiches wie für die Funktionsmodule 14, 16 gilt selbstverständlich auch für die Blenden 15.

Jede Modulaufnahme 283 verfügt über eine geräteseitige Identifikations-schnittstellenkomponente 30a, die mit einer korrespondierenden, modulseitigen Identifikations-Schnittstellenkomponente 30b eines eingesetzten Funktionsmoduls 14, 16 wechselwirken kann, um das eingesetzte Funktionsmodul 14, 16 zu identifizieren und über eine entsprechende Datenleitung (gestrichelte Linien) mit einer Steuereinheit zu verbinden.

Weiter weist jede Modulaufnahme 283 eine geräteseitige Thermo-Schnittstellenkomponente 32a auf, die mit einer korrespondierenden, modulseitigen Thermo-Schnittstellenkomponente 32b eines eingesetzten Funktionsmoduls 14, 16 in thermischem Kontakt steht. Die geräteseitigen Thermo-Schnittstellenkomponenten 32b sind untereinander sowie mit einer nicht dargestellten Kühlvorrichtung thermisch verbunden (punktierte Linien).

Weitere Schnittstellen, wie beispielsweise elektrische und datentechnische Schnittstellen zur Ansteuerung der Funktionsmodule 14, 16 sind zwar vorzugsweise vorgesehen, in den Figuren der Übersichtlichkeit halber nicht dargestellt.

Eine Besonderheit der modulseitigen Thermo-Schnittstellenkomponenten 32b der gezeigten Ausführungsform liegt darin, dass sie im Vergleich zu den geräteseitigen Thermo-Schnittstellenkomponenten 32a sowie untereinander unterschiedliche Kontaktflächengrößen aufweisen. Sämtliche modulseitigen Thermo-Schnittstellenkomponenten 32b sind kleiner als oder höchstens genauso groß wie die untereinander gleich großen, geräteseitigen Thermo-Schnittstellenkomponenten 32a. Die spezielle Größe der modulseitigen Kontaktflächen hängt von der Wärmeleistung der jeweiligen Funktionsmodule 14, 16 ab. Insbesondere kann eine Proportionalität zwischen der Wärmeleistung und der thermischen Kontaktflächengröße der Module bestehen.

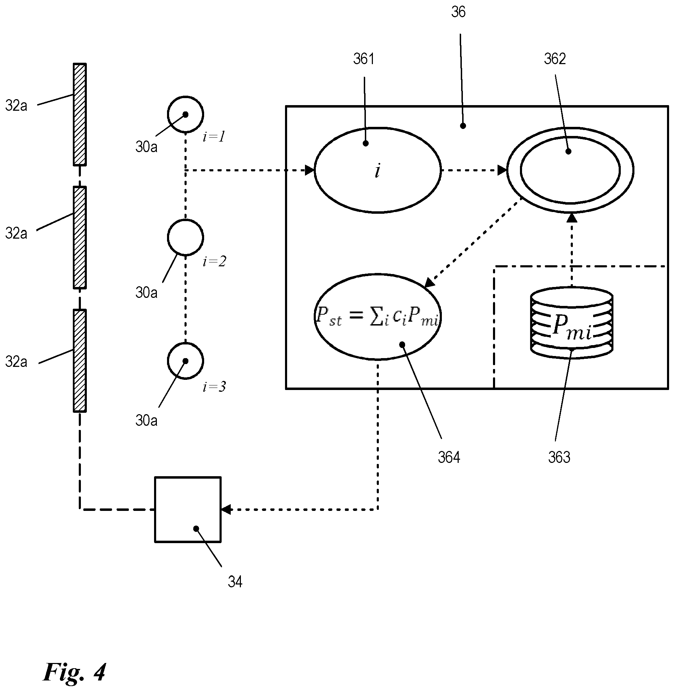

Figur 4 zeigt eine bevorzugte Ausführungsform einer Steuerung der Waage 12. Dargestellt sind die thermisch untereinander sowie mit einer Kühlvorrichtung 34 verbundenen, geräteseitigen Thermo-Schnittstellenkomponenten 32a sowie die geräteseitigen Identifikations-Schnittstellenkomponenten 30a, die hier jeweils mit dem Index i identifiziert sind. Die durch Wechselwirkung der geräteseitigen und modulseitigen Identifikations-Schnittstellenkomponenten 30a, b gewonnenen Identifikationsdaten, werden an eine Steuereinrichtung 36, dort insbesondere an die Identifikationseinheit 361 gesendet. Bei der in den Figuren 1 und 3 dargestellten Ausführungsform würde die Identifikations-Schnittstelle i=1 die Information über das eingesetzte

Beleuchtungsmodul 16 liefern. Die Identifikations-Schnittstelle i=2 würde die Information über das Fehlen eines eingesetzten Funktionsmoduls liefern und die Identifikations-Schnittstelle i=3 würde die Information über das eingesetzte Laserscanner-Modul 14 liefern. Die Identifikation kann modultypspezifisch oder sogar modulindividuell erfolgen.

Die Identifikationsdaten werden von der Identifikationseinheit 361 an eine Zentraleinheit 362 gesendet. Diese erhält aus einer Speichereinheit 363 Informationen über die konkreten Wärmeleistungen der identifizierten Funktionsmodule 14, 16. Wie durch die strichpunktierte Linie angedeutet, kann die Speichereinheit 363 in die Steuereinrichtung 36 integriert oder entfernt davon, beispielsweise in einem über Internet angebundenen Server, vorgehalten sein. Allerdings kann diese Information auch in einer Speichereinheit des Funktionsmoduls selbst vorgehalten werden. Insbesondere kann vorgesehen sein, dass das Funktionsmodul nach seiner Fertigung werksseitig im Rahmen der Qualitätskontrolle eine individuelle Messung seiner Wärmeleistung durchläuft, deren Ergebnis dann in der Speichereinheit hinterlegt wird. Auch eine typenspezifische Hinterlegung ohne individuelle Messung ist möglich. In jedem Fall verbindet die Informationshinterlegung im Modul selbst die Vorteile der Entlastung der Waagen-Steuereinheit, der Unabhängigkeit von externen Datenquellen und der Möglichkeit der Individualisierung.

Aus den Identifikationsdaten einerseits und den Wärmeleistungsdaten andererseits berechnet die Zentraleinheit 362 die Vorgabewerte zur Ansteuerung der Kühlvorrichtung 34, die an eine mit der Kühlvorrichtung verbundene Kühlungssteuerungseinheit 364 weitergegeben werden. Bei der dargestellten Ausführungsform entspricht die vorgegebene Kühlleistung Pₛₜ einer statischen Kühlleistung, die sich aus der Summe der Einzelwärmeleistungen Pₘᵢ der identifizierten Funktionsmodule 14, 16, jeweils multipliziert mit einem Wichtungsfaktor cᵢ, zusammensetzt: *Pₛₜ* = Σ*ᵢcᵢPₘᵢ.* Die Gesamtkühlleistung P ergibt sich in diesem Fall als Summe einer in Figur 4 nicht erwähnten, modulunabhängigen Grundkühlleistung Po und der modulabhängigen statischen Kühlleistung Pₛₜ : *P = P*₀ + *Pₛₜ* + *Pᵥ*

Mit dem Wichtungsfaktor cᵢ kann beispielsweise die spezielle Position, d.h. die spezielle Modulaufnahme, berücksichtigt werden, in der ein Funktionsmodul 14, 16 eingesetzt ist. Selbstverständlich kann auf eine solche Wichtung auch verzichtet werden, d.h. der Wichtungsfaktor entspricht dann 1 bzw. ist in allen Summanden identisch.

Diese statische Kühlleistung Pₛₜ wird von der Kühlvorrichtung 34 an sämtliche geräteseitigen Thermo-Schnittstellenkomponenten 32a gleich verteilt. Die jeweils bedarfsgerechte Verteilung an die Funktionsmodule 14, 16 erfolgt über die unterschiedlichen Größen der modulseitigen Thermo-Schnittstellenkomponenten 32b.

Bei einer Weiterbildung dieser Kühlungssteuerung bildet die statische Kühlleistung Pₛₜ nur einen von mehreren Termen der Gesamtkühlleistung P: *P* = *P*₀ + *Pₛₜ* + *Pᵥ* mit *Pᵥ* = *Pᵥ*(*T*)*.* Bei dieser Ausführungsform ist zusätzlich zur statischen Kühlleistung Pₛₜ noch ein geringer, geregelter Kühlleistungsbeitrag, die Korrekturkühlleistung Pᵥ vorgesehen, mit dem geringe Schwankungen der Temperatur T im Wägeraum 22 kompensiert werden können.

Natürlich stellen die in der speziellen Beschreibung diskutierten und in den Figuren gezeigten Ausführungsformen nur illustrative Ausführungsbeispiele der vorliegenden Erfindung dar. Dem Fachmann ist im Lichte der hiesigen Offenbarung ein breites Spektrum von Variationsmöglichkeiten an die Hand gegeben. Insbesondere ist es möglich, alternativ oder zusätzlich zur Wägeraumrückwand 28 eine oder mehrere der übrigen Wände der Wägeraumwandung in der beschriebenen Weise als Pfosten/Streben-Struktur mit als Modulaufnahmen ausgebildeten Ausnehmungen zu gestalten. In solchen Fällen, in denen die Modulaufnahmen nicht an einen, insbesondere aus eichrechtlichen Gründen zu versiegelnden Raum grenzen, wird eine spezielle Versiegelungswand wie bei der hier gezeigten Ausführungsform nicht erforderlich sein.

### Bezugszeichenliste

- 10: gravimetrisches Messsystem
- 12: Waage
- 14: Funktionsmodul
- 15: Blende
- 16: Funktionsmodul
- 18: Wägesystemraum
- 181: Wägesystem
- 20: Wägegutträger
- 22: Wägeraum
- 23: Wägeraumdeckel
- 24: Wägeraumboden
- 26: Wägeraumseitenwand
- 28: Wägeraumrückwand
- 281: Pfosten
- 282: Strebe
- 283: Ausnehmung/Modulaufnahme
- 284: Abschlusswand
- 30a/b: geräteseitige/modulseitige Identifikations-Schnittstellenkomponente
- 32a/b: geräteseitige/modulseitige Thermo-Schnittstellenkomponente
- 34: Kühlvorrichtung
- 36: Steuereinrichtung
- 361: Identifikationseinheit
- 362: Zentraleinheit
- 363: Speichereinheit
- 364: Kühlungssteuerungseinheit
- P: Gesamtkühlleistung
- Po: Grundkühlleistung
- Pₛₜ: statische Kühlleistung
- Pᵥ: Korrekturkühlleistung
- cᵢ: Wichtungsfaktor
- Pₘᵢ: modulspezifische Wärmeleistung
- T: Temperatur (im Wägeraum)

## Patentansprüche

1. Gravimetrisches Messsystem (10), umfassend
- eine Waage (12) mit einem von einer Mehrzahl von Wägeraumwänden (23, 24, 26, 28) umgebenen Wägeraum (22), einem elektromechanischen Wägesystem (181) und einer elektronischen Steuereinrichtung (36) zur Steuerung des Systembetriebs gemäß in ihrem Speicher (363) hinterlegten Regeln,
wobei wenigstens eine der Wägeraumwände (28) als eine Trägerstruktur ausgebildet ist, welche Freilassungen darstellende Ausnehmungen (283) aufweist,
- eine Mehrzahl von Funktionsmodulen (14, 16), die bedarfsweise in von den Ausnehmungen (283) gebildete Modulaufnahmen einsetzbar sind, sowie
- wägefunktionslose, räumlich an die Ausnehmungen (283) angepasste Blenden (15),
wobei die Ausnehmungen (283) wahlweise durch die Blenden (15) oder die Funktionsmodule (14, 16) verschließbar sind,
**dadurch gekennzeichnet,**
**dass** die Ausnehmungen (283) den überwiegenden Teil der Wandfläche der als besagte Trägerstruktur ausgebildeten Wägeraumwand (28) einnehmen und die Trägerstruktur im Bereich wenigstens einer ihrer Ausnehmungen (283) eine geräteseitige Identifikations-Schnittstellenkomponente (30a) aufweist, die beim Einsetzen eines Funktionsmoduls (14, 16) von einer korrespondierenden, modulseitigen Identifikations-Schnittstellenkomponente (30b) identifikationsdatenübertragend kontaktiert wird.

2. Gravimetrisches Messsystem (10) nach Anspruch 1
**dadurch gekennzeichnet,**
**dass** die geräteseitige Identifikations-Schnittstellenkomponente (30a) als eine optische, magnetische, taktile, funktechnische oder elektronische Empfangseinheit und die modulseitige Identifikations-Schnittstellenkomponente (30b) als eine korrespondierende optische, magnetische, taktile, funktechnische bzw. elektronische Sendeeinheit ausgebildet ist.

3. Gravimetrisches Messsystem (10) nach einem der vorangehenden Ansprüche, **dadurch gekennzeichnet,**
**dass** die Trägerstruktur im Bereich wenigstens einer ihrer Ausnehmungen (283) eine mit einer zentralen Kühlvorrichtung (34) thermisch verbundene, geräteseitige Thermo-Schnittstellenkomponente (32a) aufweist, die beim Einsetzen eines Funktionsmoduls (14, 16) von einer korrespondierenden, modulseitigen Thermo-Schnittstellenkomponente (32b) thermisch kontaktiert wird.

4. Gravimetrisches Messsystem (10) nach einem der vorangehenden Ansprüche, **dadurch gekennzeichnet,**
**dass** die als besagte Trägerstruktur ausgebildete Wägeraumwand (28) als ein Trennelement zwischen dem Wägeraum (22) und einem Wägesystemraum (18), der ein mit einem im Wägeraum (22) angeordneten Wägegutträger (20) verbundenes Wägesystem (181) umschließt, positioniert ist,
wobei die Ausnehmungen (283) der Trägerstruktur wägesystemraumseitig durch eine fest installierte Abschlusswand (284) verschlossen sind.

## Claims

1. A gravimetric measuring system (10), comprising
- a scale (12) having a weighing chamber (22) surrounded by a plurality of weighing chamber walls (23, 24, 26, 28), an electromechanical weighing system (181) and an electronic control apparatus (36) for controlling the system operation according to the rules stored in its memory (363),
wherein at least one of the weighing chamber walls (28) is configured as a carrier structure, which has recesses (283) constituting clearances,
- a plurality of function modules (14, 16), which if necessary can be inserted into module receptacles formed by the recesses (283), as well as
- diaphragms (15) which have no weighing function and are spatially adapted to the recesses (283),
wherein the recesses (283) can be optionally closed by the diaphragms (15) or the function modules (14, 16),
**characterized in that**
the recesses (283) occupy the major portion of the wall surface of the weighing chamber wall (28) configured as said carrier structure and the carrier structure has in the region of at least one of its recesses (283) a device-side identification interface component (30a), which in the event of the insertion of a function module (14, 16) from a corresponding module-side identification interface component (30b) is contacted in an identification data transferring manner.

2. The gravimetric measuring system (10) according to claim 1,
**characterized in that**
the device-side identification interface component (30a) is configured as an optical, magnetic, tactile, radio or electronic receiving unit and the module-side identification interface component (30b) is configured as a corresponding optical, magnetic, tactile, radio or electronic transmitting unit.

3. The gravimetric measuring system (10) according to any of the foregoing claims,
**characterized in that**
the carrier structure has a device-side thermal interface component (32a) thermally connected to a central cooling apparatus (34) in the region of at least one of its recesses (283), which is thermally contacted by a corresponding module-side thermal interface component (32b) when a function module (14, 16) is inserted.

4. The gravimetric measuring system (10) according to any of the foregoing claims,
**characterized in that**
the weighing chamber wall (28) configured as said carrier structure is positioned as a separating element between the weighing chamber (22) and a weighing system chamber (18), which surrounds a weighing system (181) connected to a weighing goods carrier (20) arranged in the weighing chamber (22),
wherein the recesses (283) of the carrier structure are closed on the weighing system chamber-side by a firmly installed end wall (284).

## Revendications

1. Système de mesurage (10) gravimétrique, qui comprend
- une balance (12) avec une chambre de pesée (22) entourée d'une pluralité de parois de chambre de pesée (23, 24, 26, 28), un système de pesée (181) électromécanique et un équipement de commande (36) électronique pour commander le fonctionnement du système en fonction de règles déposées dans sa mémoire (363),
dans lequel au moins une des parois de chambre de pesée (28) est conçue en tant que structure porteuse, laquelle présente des évidements (283) qui représentent des libérations,
- une pluralité de modules fonctionnels (14, 16), qui au besoin peuvent être utilisés dans des réceptions de module formées par les évidements (283), ainsi que
- des obturateurs (15) sans fonction de pesée et spatialement adaptées aux évidements (283),
dans lequel les évidements (283) peuvent être fermés au choix par les obturateurs (15) ou par les modules fonctionnels (14, 16),
**caractérisé en ce que**
les évidements (283) occupent la majeure partie de la surface de paroi de la paroi de chambre de pesée (28) conçue en tant que ladite structure porteuse et la structure porteuse présente, dans la région d'au moins un de ses évidements (283), un composant d'interface d'identification (30a) sur le côté de l'appareil qui, lors de l'utilisation d'un module fonctionnel (14, 16) d'un composant d'interface d'identification (30b) correspondant sur le côté du module, est amené en contact en transmettant des données d'identification.

2. Système de mesurage (10) gravimétrique selon la revendication 1,
**caractérisé en ce que**
le composant d'interface d'identification (30a) sur le côté de l'appareil est conçu en tant qu'unité de réception optique, magnétique, tactile, radiotechnique ou électronique et le composant d'interface d'identification (30b) sur le côté du module est conçu en tant qu'unité d'envoi correspondante optique, magnétique, tactile, radiotechnique ou électronique.

3. Système de mesurage (10) gravimétrique selon l'une des revendications précédentes,
**caractérisé en ce que**
la structure porteuse présente, dans la région d'au moins un de ses évidements (283), un composant d'interface thermique (32a) sur le côté de l'appareil qui est thermiquement relié à un dispositif de refroidissement (34) central, lequel composant d'interface thermique, lors de l'utilisation d'un module fonctionnel (14, 16) d'un composant d'interface thermique (32b) correspondant sur le côté du module, est amené thermiquement en contact.

4. Système de mesurage (10) gravimétrique selon l'une des revendications précédentes,
**caractérisé en ce que**
la paroi de chambre de pesée (28) conçue en tant que ladite structure porteuse est positionnée en tant qu'élément de séparation entre la chambre de pesée (22) et une chambre de système de pesée (18) qui englobe un système de pesée (181) relié à un support de produit à peser (20) agencé dans la chambre de pesée (22),
dans lequel les évidements (283) de la structure porteuse sur le côté du système de pesée sont fermés par une paroi de fermeture (284) solidement installée.
